# FASCICULE DE BREVET EUROPEEN

(11) **EP 3 256 983 B1**
(45) Date de publication et mention de la délivrance du brevet: **21.08.2019**
(21) Numéro de dépôt: 16707184.4
(22) Date de dépôt: 09.02.2016
(51) Int. Cl.: G06K 7/10, H01H 9/16, H05B 37/02, H05K 7/14, H02B 1/052

(54) **APPAREIL ELECTRIQUE, SYSTEME COMPRENANT UN TEL APPAREIL ELECTRIQUE ET PROCEDE MIS EN OEUVRE DANS UN TEL SYSTEME**
ELEKTRISCHES GERÄT, SYSTEM MIT SOLCH EINEM GERÄT UND IN EINEM SOLCHEN SYSTEM AUSGEFÜHRTES VERFAHREN
ELECTRICAL APPARATUS, SYSTEM WITH SUCH AN APPARATUS AND PROCESS IMPLEMENTED IN SUCH A SYSTEM

(30) Priorité: 12.02.2015 FR 1551165
(43) Date de publication de la demande: 20.12.2017
(73) Titulaire: Legrand France, 87000 Limoges (FR); Legrand SNC, 87000 Limoges (FR)
(72) Inventeur: COUJEAN, Laurent, 87570 Rilhac Rancon (FR); COUSSEDIERE, Alexandre, 87570 Rilhac Rancon (FR)
(74) Mandataire: Jacobacci Coralis Harle
(86) Numéro de dépôt international: PCT/FR2016/050285
(87) Numéro de publication internationale: WO 2016/128668

(56) Documents cités:
- EP-A1- 1 179 827
- WO-A1-2013/033257
- WO-A1-2015/025267
- US-A1- 2014 084 707

## Description

### DOMAINE TECHNIQUE AUQUEL SE RAPPORTE L'INVENTION

La présente invention concerne l'appareillage électrique.

Elle concerne plus particulièrement un appareil électrique, un système comprenant un tel appareil électrique et un procédé mis en oeuvre dans un tel système.

### ARRIERE-PLAN TECHNOLOGIQUE

On connaît, par exemple du document FR 2 994 346, un appareil électrique comprenant un boîtier comportant des moyens de positionnement dans un réceptacle d'appareillage électrique et un circuit électronique conçu pour manipuler une information de commande d'une charge.

Grâce à leurs moyens de positionnement, de tels appareils électriques peuvent être montés dans un réceptacle d'appareillage électrique, tel qu'un tableau électrique ou une boîte d'encastrement.

On connaît par ailleurs du document WO 2013/033 257 un dispositif de régulation de charge et une télécommande, qui peuvent être montés sur un coffret électrique mural et qui peuvent comprendre des modules de communication en champ proche pour communiquer sans fil via un rayonnement en champ proche.

### OBJET DE L'INVENTION

La présente invention propose un appareil électrique conforme à la revendication 1.

Un tel appareil électrique peut ainsi établir une communication de proximité avec un autre dispositif positionné dans le réceptacle (tableau électrique ou boîte d'encastrement), ou dans un réceptacle voisin, et échanger par ce biais des données avec l'autre dispositif, ce qui élargit par exemple les possibilités de commande et de diagnostic de l'appareil électrique.

On profite donc du positionnement attendu de l'appareil électrique dans son réceptacle pour établir une communication de proximité, dont la mise en oeuvre est simple et peu onéreuse.

Le circuit électronique est par exemple un processeur relié au module de communication de proximité, comme expliqué dans les exemples décrits dans la suite.

La communication de proximité (ou communication sans fil de proximité) est une communication sans fil courte portée (parfois définie par une portée inférieure à 15 cm), par exemple une communication conforme à la norme ISO14443, telle qu'utilisée notamment dans le cadre de la norme NFC (pour "Near *Field Communication"* : communication en champ proche).

D'autres caractéristiques avantageuses et non limitatives de l'appareil électrique conforme à l'invention sont les suivantes :
- l'appareil électrique comprend au moins un contact d'entrée, un contact de sortie et un interrupteur commandé conçu pour commander l'ouverture ou la fermeture d'un chemin électrique entre le contact d'entrée et le contact de sortie (l'interrupteur commandé étant par exemple interposé entre le contact d'entrée et le contact de sortie) ;
- le circuit électronique est conçu pour commander l'interrupteur commandé en fonction de ladite information de commande ;
- l'antenne est montée à proximité d'une paroi du boîtier ;
- l'antenne est une antenne plane intégrée dans une telle paroi ;
- l'antenne est une antenne plane, qui peut par exemple être située, dans son ensemble, à moins de 5 mm de la paroi ;
- la paroi est une paroi latérale du boîtier ;
- le boîtier comporte deux antennes situées respectivement à proximité de deux parois du boîtier ;
- les moyens de positionnement comprennent une encoche de montage sur un rail de support ;
- les moyens de positionnement comprennent un support d'appareillage ;
- le circuit électronique est conçu pour transmettre lesdites données via la liaison sans fil de proximité établie entre l'appareil électrique et le second appareil électrique voisin suite à une consultation d'un identifiant du second appareil électrique voisin annexé auxdites données.

L'invention propose également un système comprenant un premier appareil électrique et un second appareil électrique tels que décrit ci-dessus, dans lequel le premier appareil électrique et le second appareil électrique sont juxtaposés de manière à établir une communication sans fil de proximité entre le module de communication de proximité du premier appareil électrique et le module de communication de proximité du second appareil électrique.

Le premier appareil électrique et le second appareil électrique peuvent par exemple être montés juxtaposés sur un rail de support d'un tableau électrique ou dans une boîte d'encastrement.

Le système peut comprendre en outre un troisième appareil électrique tel que proposé ci-dessus ; le second appareil électrique et le troisième appareil électrique peuvent être juxtaposés de manière à établir une communication sans fil de proximité entre le module de communication de proximité du second appareil électrique et le module de communication de proximité du troisième appareil électrique.

Dans un tel système peut être mis en oeuvre un procédé comprenant les étapes suivantes :
- réception de données par le premier appareil électrique (via une autre liaison sans fil de proximité ou via un réseau informatique) ;
- transmission des données reçues du premier appareil électrique au second appareil électrique via la communication sans fil de proximité établie.

Le circuit électronique du second appareil électrique peut alors par exemple commander l'interrupteur commandé du second appareil électrique en fonction des données transmises.

On peut également envisager de mettre en oeuvre dans un tel système un procédé comprenant les étapes suivantes :
- détermination d'une information de commande de charge par le premier appareil électrique ;
- transmission de l'information de commande de charge déterminée du premier appareil électrique au second appareil électrique via la communication sans fil établie.

Le circuit électronique du second appareil électrique peut alors éventuellement commander l'interrupteur commandé du second appareil électrique en fonction de l'information de commande de charge transmise. En variante, le second appareil électrique pourrait transmettre l'information de commande de charge à un autre appareil électrique via une autre liaison sans fil de proximité ou un réseau informatique.

L'invention propose en outre un système comprenant un appareil électrique tel que décrit ci-dessus et une passerelle de communication comprenant un autre module de communication de proximité, dans lequel l'appareil électrique et la passerelle de communication sont juxtaposés de manière à établir une communication sans fil de proximité entre le module de communication de proximité de l'appareil électrique et ledit autre module de communication de proximité.

L'appareil électrique et la passerelle de communication sont par exemple montés juxtaposés sur un rail de support d'un tableau électrique ou dans une boîte d'encastrement.

Dans un tel système peut être mis en oeuvre un procédé comprenant les étapes suivantes :
- réception de données par la passerelle de communication ;
- transmission desdites données de la passerelle de communication à l'appareil électrique via la communication sans fil de proximité établie,
et/ou un procédé comprenant les étapes suivantes :
- transmission de données de l'appareil électrique à la passerelle de communication via la communication sans fil de proximité établie ;
- émission desdites données par la passerelle de communication à destination d'un dispositif électronique en communication avec la passerelle électronique.

Dans le système comprenant trois appareils électriques comme mentionné ci-dessus, un procédé selon l'invention comprenant les étapes suivantes peut être mis en oeuvre :
- transmission de données du premier appareil électrique au second appareil électrique via la communication sans fil de proximité établie entre le module de communication de proximité du premier appareil électrique et le module de communication de proximité du second appareil électrique ;
- transmission desdites données du second appareil électrique au troisième appareil électrique via la communication sans fil de proximité établie entre le module de communication de proximité du second appareil électrique et le module de communication de proximité du troisième appareil électrique.

### DESCRIPTION DETAILLEE D'EXEMPLES DE REALISATION

La description qui va suivre en regard des dessins annexés, donnés à titre d'exemples non limitatifs, fera bien comprendre en quoi consiste l'invention et comment elle peut être réalisée.

Sur les dessins annexés :
- la figure 1 est une vue en perspective d'un exemple d'appareil électrique conforme à l'invention ;
- la figure 2 représente les composants principaux du circuit électrique de l'appareil électrique de la figure 1 ;
- la figure 3 est une vue en perspective d'une passerelle de communication utilisable dans le cadre de l'invention ;
- la figure 4 représente les composants principaux du circuit électrique de la passerelle de communication de la figure 3 ;
- la figure 5 est une vue de face de l'appareil électrique de la figure 1 et de la passerelle de communication de la figure 3 montés sur un même rail de support ;
- la figure 6 représente schématiquement un autre cas d'utilisation de l'appareil électrique de la figure 1 et de la passerelle de communication de la figure 3 ;
- la figure 7 représente schématiquement un exemple d'installation électrique comprenant une pluralité d'appareils électriques conformes à l'invention ;
- la figure 8 représente les principaux composants d'un élément de commande modulaire conforme à l'invention ;
- la figure 9 représente un exemple d'installation électrique comprenant notamment l'élément de commande modulaire de la figure 8 ;
- la figure 10 représente les éléments principaux d'un autre appareil électrique conforme à l'invention ;
- la figure 11 représente schématiquement l'appareil électrique de la figure 10 logé dans une boîte d'encastrement et monté, avec un autre mécanisme d'appareillage, sur un support d'appareillage ;
- la figure 12 représente une variante de réalisation de l'appareil électrique de la figure 10 ;
- la figure 13 représente schématiquement un support d'appareillage pourvu de trois appareils électriques selon l'invention.

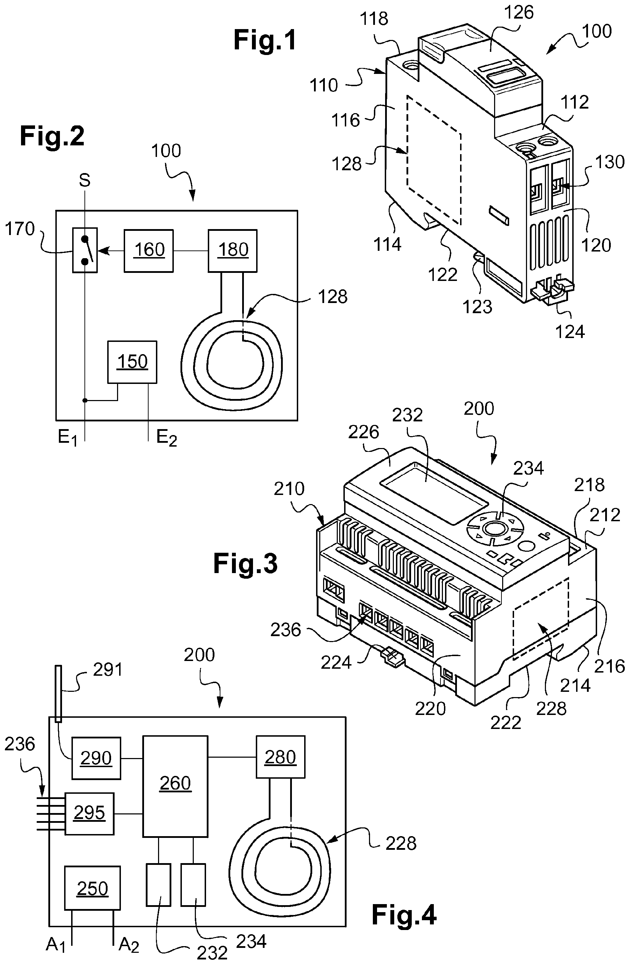

On a représenté sur la figure 1 un exemple d'appareil électrique conforme à l'invention, ici un élément modulaire 100.

L'élément modulaire 100 (ici un variateur modulaire) est destiné à être monté dans un tableau électrique (ou armoire électrique) et présente notamment pour ce faire un encombrement latéral standardisé, ici de 18 mm (qui pourrait en variante être un multiple de 18 mm).

L'élément modulaire 100 comprend un boîtier 110 de forme globalement parallélépipédique présentant une face avant 112 (en haut sur la figure 1), une face arrière 114 (en bas sur la figure 1), deux faces latérales parallèles 116 (distantes dudit encombrement latéral), une face supérieure 118 et une face inférieure 120.

On comprend que les faces sont dénommées d'après leur situation en position montée de l'élément modulaire dans un tableau électrique.

Une encoche 122 est formée dans la face arrière 114 afin de pouvoir monter l'élément modulaire sur un rail de support (par exemple un rail de type din Ω) du tableau électrique par coopération (par complémentarité de formes) du rail et de l'encoche 122.

Un verrou 123, déplaçable par action sur un élément de manoeuvre 124 prévu sur la face inférieure 120, est prévu dans l'encoche 122 : en position montée, ce verrou 123 enserre (avec une partie opposée de l'encoche 122) le rail de support afin d'immobiliser l'élément modulaire 100 dans le tableau électrique ; par ailleurs, lorsque le verrou 123 est déplacé par action sur l'élément de manoeuvre 124 (typiquement à l'aide d'un tournevis), la largeur de l'encoche 122 s'élargit, ce qui permet le démontage de l'élément modulaire.

La face avant 112 présente, dans une zone médiane, une partie de façade 126 qui s'étend à l'avant (*i.e*. vers le haut sur la figure 1) par rapport à des zones supérieure et inférieure de la face avant 112 de sorte que la partie de façade 126 émerge hors d'un plastron du tableau électrique, à travers une fenêtre formée dans ce plastron.

Le boîtier 110 renferme une antenne 128, ici une antenne plane qui s'étend dans un plan (au moins essentiellement) parallèle à l'une au moins des faces latérales 116 du boîtier 110. L'antenne 128 est par exemple formée d'enroulements et est connectée au circuit électrique de l'élément modulaire, comme expliqué ci-après. L'antenne 128 est ici une antenne magnétique.

L'élément modulaire 100 de la figure 1 comporte deux antennes du type de l'antenne 128, disposées chacune parallèlement et à proximité d'une face latérale correspondante 116, par exemple à une distance inférieure à 5 mm de la face latérale correspondante 116. Une seule antenne 128 est toutefois représentée sur le schéma électrique de la figure 2 par mesure de simplification. En variante, et dans le cas notamment d'un élément modulaire à un module (de largeur standardisée 18 mm), l'élément modulaire 100 peut comporter une seule antenne.

Certaines faces du boîtier 110, par exemple la face supérieure 118 et la face inférieure 120, présentent des bornes de connexion 130 destinées chacune au branchement d'un câble de l'installation électrique dont le tableau électrique fait partie.

On décrit à présent en référence à la figure 2 les principaux composants du circuit électrique de l'élément modulaire 100.

Ce circuit électrique présente un premier contact d'entrée E₁, un second contact d'entrée E₂ et un contact de sortie S. Chacun de ces contacts E₁, E₂, S correspond à une borne de connexion 130 formée comme déjà indiqué à la surface du boîtier 110 de l'élément modulaire 100, par exemple en face supérieure 118 ou en face inférieure 120.

Le premier contact d'entrée E₁ est destiné à être connecté à un câble de phase P de l'installation électrique, le second contact d'entrée E₂ est destiné à être connecté à un câble de neutre N de l'installation électrique et le contact de sortie S est destiné à être connecté à une charge à alimenter par l'intermédiaire de l'élément modulaire 100 (ici un variateur modulaire comme déjà indiqué).

Le câble de phase P et le câble de neutre N sont des câbles d'alimentation électrique, entre lesquels est présente une tension d'alimentation alternative (tension secteur).

L'élément modulaire 100 comprend un circuit d'alimentation 150 connecté au premier contact d'entrée E₁ et au second contact d'entrée E₂ et conçu pour transformer la tension secteur en tension continue destinée à alimenter les autres composants du circuit électrique de l'élément modulaire 100.

L'élément modulaire 100 comprend par ailleurs un processeur 160 (par exemple un microcontrôleur) conçu pour gérer le fonctionnement de l'élément modulaire 100 et pour commander un interrupteur commandé 170 connecté entre le premier contact d'entrée E₁ et le contact de sortie S.

Dans le cas présent où l'élément modulaire 100 est un variateur modulaire comme déjà indiqué, le processeur 160 est conçu pour commander l'interrupteur commandé 170 de manière à ce que ce dernier ne soit conducteur que pour une partie déterminée de chaque période de la tension secteur et bloqué le reste du temps, ce qui permet de ne transmettre à la charge (par exemple une lampe) qu'une partie de la puissance disponible.

La puissance transmise à la charge est réglable en fonction de la proportion du temps pendant laquelle l'interrupteur commandé est conducteur (ou passant), couramment dénommée rapport cyclique.

L'élément modulaire 100 comprend un module NFC ou module de communication en champ proche 180 (NFC étant l'acronyme de *"Near Field Communication",* communication en champ proche). Le module NFC 180 est relié au processeur 160, par exemple au moyen d'un bus de données, et connecté à l'antenne 128 déjà mentionnée. Le module NFC 180 forme un module (ou interface) de communication (sans fil) de proximité.

Lorsque plusieurs antennes 128 sont utilisées, les différentes antennes sont chacune reliées à un module NFC 180.

Comme décrit ci-après, le module NFC 180 permet à l'élément modulaire 100 (c'est-à-dire en pratique à son processeur 160) d'entrer en communication, via une communication sans fil de proximité, avec un autre appareil équipé d'un module NFC et d'échanger des données avec cet autre appareil.

Bien que cela ne soit pas représenté en figure 2 par mesure de simplification, le processeur 160 et le module NFC 180 (ainsi qu'éventuellement l'interrupteur commandé 170) sont alimentés par la tension continue générée par le circuit d'alimentation 150.

On a représenté sur la figure 3 un exemple de passerelle de communication 200 utilisable dans le cadre de l'invention, réalisée ici sous la forme d'un élément modulaire destiné à être monté dans un tableau électrique, comme l'élément modulaire 100 de la figure 1.

La passerelle de communication 200 présente notamment pour ce faire un encombrement latéral standardisé, par exemple multiple de 18 mm.

La passerelle de communication 200 comprend un boîtier 210 de forme globalement parallélépipédique présentant une face avant 212 (en haut sur la figure 3), une face arrière 214 (en bas sur la figure 3), deux faces latérales parallèles 216 (distantes dudit encombrement latéral), une face supérieure 218 et une face inférieure 220.

Comme pour la figure 1, les faces sont dénommées d'après leur situation en position montée de la passerelle de communication 200 dans un tableau électrique.

La face avant 212 présente, dans une zone médiane, une partie de façade 226 qui s'étend à l'avant (*i.e*. vers le haut sur la figure 1) par rapport à des zones supérieure et inférieure de la face avant 212 de sorte que la partie de façade 226 émerge hors d'un plastron du tableau électrique, à travers une fenêtre formée dans ce plastron.

La partie de façade 226 comporte un écran 232 et un clavier 234 qui forment ensemble une interface utilisateur (ou interface homme-machine) et qui sont donc accessibles par l'utilisateur (du fait que la partie de façade 226 émerge hors du plastron comme indiqué ci-dessus). L'interface utilisateur pourrait comprendre, en variante ou en supplément, une (ou plusieurs) diode(s) électroluminescente(s) et/ou une (ou plusieurs) roue(s) codeuse(s) et/ou un (ou plusieurs) interrupteur(s).

Une encoche 222 est formée dans la face arrière 214 afin de pouvoir monter la passerelle de communication 200 sur un rail de support du tableau électrique par coopération (par complémentarité de formes) du rail et de l'encoche 122.

Un élément de manoeuvre 224 s'étend par ailleurs à partir de la face inférieure 220 : cet élément de manoeuvre 224 est solidaire d'un verrou rétractable (non visible sur la figure 3) destiné à immobiliser la passerelle de communication 200 dans le tableau électrique.

Le boîtier 210 renferme une antenne 228, ici une antenne plane qui s'étend dans un plan (au moins essentiellement) parallèle à l'une au moins des faces latérales 216 du boîtier 210. L'antenne 228 est par exemple formée d'enroulements et est connectée au circuit électrique de la passerelle de communication 200, comme expliqué ci-après. L'antenne 228 est ici une antenne magnétique.

La passerelle de communication 200 de la figure 3 comporte deux antennes du type de l'antenne 228, disposées chacune parallèlement et à proximité d'une face latérale correspondante 216, par exemple à une distance inférieure à 5 mm de la face latérale correspondante 216. Une seule antenne 228 est toutefois représentée sur le schéma électrique de la figure 4 par mesure de simplification.

Au moins une face du boîtier 210, par exemple la face supérieure 218 ou la face inférieure 220, présente des bornes de connexion destinées chacune au branchement d'un câble de l'installation électrique dont le tableau électrique fait partie.

Par ailleurs, au moins une face du boîtier 210 (ici la face inférieure 220) présente une prise media 236, par exemple une prise Ethernet, adaptée à recevoir un câble de connexion à un réseau informatique (la face inférieure 220 présentant cinq prises de ce type dans l'exemple de la figure 3).

On décrit à présent en référence à la figure 4 les principaux composants du circuit électrique de la passerelle de communication 200 de la figure 3.

Ce circuit électrique comprend un circuit d'alimentation 250 connecté à deux bornes de connexion A₁, A₂ destinées à recevoir deux câbles d'alimentation de l'installation électrique entre lesquels est présente la tension secteur. Le circuit d'alimentation 250 est conçu pour transformer la tension secteur en tension continue destinée à alimenter les autres composants du circuit électrique de la passerelle de communication 200.

La passerelle de communication 200 comprend un processeur 260 (par exemple un microcontrôleur) relié à d'autres composants : l'écran 232, le clavier 234, un module NFC 280, un module de communication sans fil 290 et un module de communication filaire 295.

Dans l'exemple de la figure 4, le processeur 260 est relié à chacun de ces composants au moyen d'une liaison dédiée. En variante, certains des composants au moins pourraient être reliés à un bus de données commun, auquel serait également relié le processeur 260.

Par ailleurs, bien que cela ne soit pas représenté en figure 4 par mesure de simplification, l'ensemble des composants précités (y compris le processeur 260) sont alimentés par la tension continue générée par le circuit d'alimentation 250.

Le module NFC 280 est connecté à l'antenne 228 déjà mentionnée et permet à la passerelle de communication 200 (c'est-à-dire en pratique à son processeur 260) d'entrer en communication, via une communication sans fil de proximité, avec un autre appareil équipé d'un module NFC et d'échanger des données avec cet autre appareil. Le module NFC 280 forme ainsi un module (ou interface) de communication (sans fil) de proximité.

Comme expliqué ci-dessus pour l'élément modulaire 100, lorsque la passerelle de communication 200 comprend plusieurs antennes, celles-ci sont chacune connectées à un module NFC propre.

Le module de communication sans fil 290 est branché à une antenne électromagnétique 291 au moyen de laquelle le module de communication sans fil 290 émet et reçoit des signaux électromagnétiques représentatifs de données échangées, par exemple conformément au protocole ZigBee ou à un autre protocole sans fil (par exemple Bluetooth ou WiFi).

Le module de communication sans fil 290 permet ainsi d'établir un réseau local sans fil (ou WLAN pour "*Wireless Local Area Network*") ou un réseau personnel sans fil (ou WPAN pour "*Wireless Personal Area Network*") avec au moins un autre appareil équipé d'un module de communication du même type.

Le module de communication filaire 295 est connecté à chacune des prises media 236 et permet l'établissement d'un réseau informatique (filaire) entre la passerelle de communication 200 et un autre appareil branché à un câble de connexion enfiché dans l'une des prises media 236. Cet autre appareil et la passerelle de communication 200 peuvent ainsi échanger des données à travers ce réseau informatique, par exemple selon un protocole de type IP, DALI ou KNX.

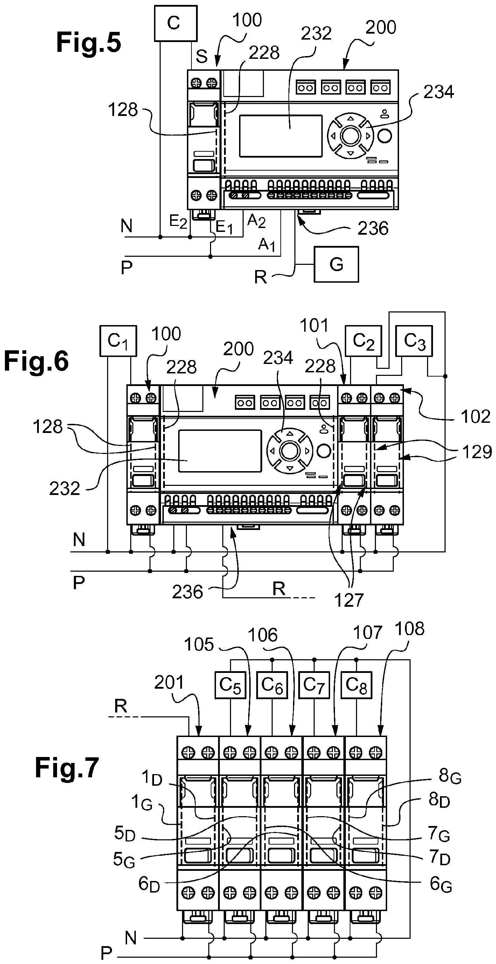

Comme représenté en figure 5, l'élément modulaire 100 et la passerelle de communication 200 peuvent être montés côte à côte (c'est-à-dire juxtaposés) sur un même rail de support d'un tableau électrique de sorte que l'une des faces latérales 116 de l'élément modulaire 100 soit positionnée au contact (ou à une distance très faible, typiquement inférieure à 2 mm) de l'une des faces latérales 216 de la passerelle de communication 200.

Le premier contact d'entrée E₁ de l'élément modulaire 100 et une borne de connexion A₁ de la passerelle de communication 200 sont branchés sur la phase P de l'installation électrique. Le second contact d'entrée E₂ de l'élément modulaire 100 et l'autre borne de connexion A₂ de la passerelle de communication 200 sont branchés sur le neutre N de l'installation électrique. Une charge C (typiquement une lampe) est branchée entre le contact de sortie S de l'élément modulaire 100 et le neutre N.

On a schématiquement représenté en pointillés sur la figure 5 les antennes 128, 228 respectivement prévues dans l'élément modulaire 100 et dans la passerelle de communication 200 à proximité de la face latérale 116, 216 concernée.

Du fait du positionnement de l'élément modulaire 100 et de la passerelle de communication 200 l'un contre l'autre sur le rail de support du tableau électrique, les antennes 128, 228 représentées en figure 5 sont situées à faible distance l'une de l'autre, ici une distance d'environ 10 mm, de manière générale inférieure à 20 mm (même lorsque les faces latérales 116, 216 sont séparées de 2 mm).

Les modules NFC équipant respectivement l'élément modulaire 100 et la passerelle de communication 200 et connectés respectivement aux antennes 128 et 228 peuvent donc établir un canal de communication sans fil de proximité, ce qui permet au processeur 160 de l'élément modulaire 100 et au processeur 260 de la passerelle de communication 200 d'échanger des données à travers ce canal de communication.

Ainsi, le processeur 160 de l'élément modulaire 100 peut recevoir des informations de commande de la charge C en provenance du processeur 260 de la passerelle de communication 200, notamment :
- des commandes (par exemple une commande d'alimentation de la charge C par fermeture de l'interrupteur commandé 170 ou une commande d'arrêt d'alimentation de la charge C par ouverture de l'interrupteur commandé 170) ;
- des valeurs de consigne à utiliser par le processeur 160 pour la commande d'un autre composant de l'élément modulaire (par exemple une valeur de consigne de rapport cyclique à utiliser pour la commande de l'interrupteur commandé 170) ;
- des paramètres de fonctionnement à mémoriser au sein du processeur 160 (par exemple dans une mémoire non-volatile réinscriptible du microcontrôleur formant le processeur 160), par exemple une donnée représentative du type (inductif ou capacitif) de la charge C, une donnée représentative du niveau minimum de puissance délivrée, une donnée représentative du niveau maximum de puissance délivrée, etc.

Les données envoyées par le processeur 260 de la passerelle de communication 200 au processeur 160 de l'élément modulaire 100 peuvent être déterminées par le processeur 260, en fonction par exemple d'informations reçues de l'utilisateur au moyen de l'interface utilisateur formée par l'écran 232 et le clavier 234, ou reçues par le processeur 260 en provenance d'un appareil extérieur, par exemple un gestionnaire G de l'installation électrique relié à la passerelle de communication 200 via un réseau domotique R (dont un câble est branché sur l'une des prises media 236).

En variante, le processeur 260 de la passerelle de communication 200 pourrait recevoir ces données d'un appareil extérieur, tel que le gestionnaire G de l'installation électrique, au moyen d'une communication sans fil établie au moyen du module de communication sans fil 290.

Le processeur 160 de l'élément modulaire 100 peut lui aussi envoyer des données au processeur 260 de la passerelle de communication 200 via la liaison de communication sans fil de proximité établie au moyen des modules NFC 180, 280. Ces données comprennent par exemple un indicateur de bon fonctionnement, un indicateur d'anomalie, un code d'erreur, des données de diagnostic, des statistiques de fonctionnement, etc.

À réception de telles données en provenance du processeur 160 de l'élément modulaire 100, le processeur 260 de la passerelle de communication 200 peut afficher sur l'écran 232 une indication associée à une donnée reçue (par exemple une indication de bon fonctionnement à réception d'un indicateur de bon fonctionnement), éventuellement après sélection (par l'utilisateur au moyen du clavier 234) d'une page d'information relative à l'élément modulaire 100.

Le processeur 260 de la passerelle de communication 200 peut également transmettre ces données à un dispositif extérieur, tel que le gestionnaire G de l'installation électrique, via le réseau (filaire) domotique R ou, en variante, via une communication sans fil au moyen du module de communication 290.

Selon une possibilité de réalisation, le module NFC 280 permet également d'établir une communication sans fil de proximité avec un dispositif électronique extérieur (équipé lui aussi de moyens de communication en champ proche) disposé par l'utilisateur à proximité de la passerelle de communication 200, éventuellement au moyen d'une antenne supplémentaire reliée à un autre module NFC et disposée par exemple à proximité de la partie de façade 226.

Des données telles que celles décrites ci-dessus (commandes, valeurs de consignes, paramètres de fonctionnement, indicateur de bon fonctionnement, indicateur d'anomalie, code d'erreur, données de diagnostic, statistiques de fonctionnement) pourront ainsi être échangées entre le dispositif électronique extérieur (par exemple un dispositif intelligent à écran tactile tel qu'une tablette ou un téléphone mobile) et le processeur 160 de l'élément modulaire 100, via le processeur 260 de la passerelle de communication 200.

La figure 6 représente un autre exemple d'utilisation de l'élément modulaire 100 de la figure 1 et de la passerelle de communication 200 de la figure 3.

Dans cet exemple sont montés juxtaposés dans cet ordre sur un rail de support d'un tableau électrique : l'élément modulaire 100 (premier variateur modulaire), la passerelle de communication 200, un second variateur modulaire 101 du même type que l'élément modulaire 100, un troisième variateur modulaire 102 du même type que l'élément modulaire 100.

Chacun de ces éléments modulaires (variateur modulaire ou passerelle de communication) est au contact, au niveau d'une au moins de ces parois latérales, du ou des élément(s) modulaire(s) voisin(s).

Comme déjà indiqué, le premier variateur modulaire 100 comprend deux antennes 128 disposées chacune à proximité immédiate d'une paroi latérale 116 (par exemple parallèlement à celle-ci) et la passerelle de communication 200 comprend deux antennes 228 disposées chacune à proximité immédiate d'une paroi latérale 216 (par exemple parallèlement à celle-ci).

De même, comme schématiquement illustré en figure 6, le second variateur modulaire 101 comprend deux antennes 127 disposées chacune à proximité immédiate d'une paroi latérale respective du boîtier du second variateur modulaire 101 (par exemple parallèlement à celle-ci) et le troisième variateur modulaire 102 comprend deux antennes 129 disposées chacune à proximité immédiate d'une paroi latérale respective du boîtier du troisième variateur modulaire 102 (par exemple parallèlement à celle-ci).

Chacun des variateurs modulaires 100, 101, 102 est branché d'une part sur un câble de phase P de l'installation électrique et d'autre part sur un câble de neutre N de l'installation électrique.

Trois charges C₁, C₂, C₃ sont branchées respectivement au premier variateur 100, au second variateur 101 et au troisième variateur 102, chaque fois au niveau de la borne de sortie (correspondant au contact de sortie S) du variateur concerné. Chaque charge C₁, C₂, C₃ est également branchée sur le câble de neutre N de l'installation électrique.

La passerelle de communication 200 est également branchée d'une part sur le câble de phase P et d'autre part sur le câble de neutre N. Comme déjà expliqué ci-dessus, la passerelle de communication 200 peut échanger des données avec un autre dispositif électronique, par exemple au moyen d'un réseau domotique filaire R connecté à la passerelle de communication 200 au niveau de la prise 236.

Du fait du positionnement des éléments modulaires 100, 200, 101, 102 sur le rail de support, chacun étant au contact d'au moins un élément modulaire voisin comme déjà indiqué, chaque élément modulaire 100, 200, 101, 102 peut échanger des données (et notamment des informations de commande d'une charge) avec au moins un élément modulaire voisin au moyen notamment de l'antenne située dans l'élément modulaire concerné à proximité de la paroi latérale au contact de l'élément modulaire voisin.

Ainsi par exemple, le troisième variateur modulaire 102 (en pratique le processeur inclus dans le troisième variateur modulaire 102) peut échanger des données avec le second variateur modulaire 101 (en pratique avec le processeur inclus dans le second variateur modulaire 101) en utilisant l'antenne 129 du troisième variateur modulaire 102 située à proximité de la paroi latérale du troisième variateur modulaire 102 en contact avec le second variateur modulaire 101 et l'antenne 127 du second variateur modulaire 101 située à proximité de la paroi latérale du second variateur modulaire 101 en contact avec le troisième variateur modulaire 102.

Par ailleurs, chacun des premier et second variateurs modulaires 100, 101 peut échanger des données avec la passerelle de communication 200 comme expliqué ci-dessus en référence à la figure 5.

Les données concernées sont par exemple des données de l'un au moins des types envisagés ci-dessus : commandes, valeurs de consignes, paramètres de fonctionnement, indicateur de bon fonctionnement, indicateur d'anomalie, code d'erreur, données de diagnostic, statistiques de fonctionnement.

On prévoit par exemple d'associer à chaque donnée ou ensemble de données une information complémentaire désignant l'élément modulaire destinataire des données, par exemple sous forme d'un identifiant de l'élément modulaire destinataire.

Ainsi par exemple, si la passerelle de communication 200 doit émettre des données (telles qu'une commande, une valeur de consigne ou un paramètre de fonctionnement) destinées au processeur du troisième variateur modulaire 102, un identifiant du troisième variateur modulaire 102 est annexé à ces données.

Ces données sont transmises (par liaison NFC) de la passerelle de communication 200 au processeur du second variateur modulaire 101 qui détermine que les données ne lui sont pas destinées (car l'identifiant annexé n'est pas son propre identifiant) et transmet les données à l'élément modulaire voisin via la liaison NFC établie entre ces éléments modulaires (ici le second variateur modulaire 101 et le troisième variateur modulaire 102).

Le processeur du troisième élément modulaire 102 reçoit alors les données et détermine que ces données lui sont destinées en consultant l'identifiant annexé et en déterminant que celui-ci est son propre identifiant.

Comme expliqué en référence à la figure 5, les données émises par la passerelle de communication 200 peuvent être générées en fonction d'informations reçues de l'utilisateur (par exemple au moyen du clavier 234) ou reçues d'un autre dispositif électronique extérieur (par exemple connecté sur le réseau domotique R).

Les identifiants à annexer aux données transmises pour indiquer leur destinataire sont configurés au préalable, par exemple à chaque ajout d'un nouvel élément modulaire au contact d'un élément modulaire déjà présent, et au moyen de l'interface homme-machine formé par le clavier 234 et l'écran 232.

On remarque qu'une telle étape de configuration peut inclure la définition de la topologie du réseau formé par les différents éléments modulaires (c'est-à-dire la donnée de leur position relative) afin qu'un élément modulaire puisse connaître les éléments modulaires intermédiaires à travers lesquels doivent transiter des données relatives à un élément modulaire destinataire.

En variante, les données peuvent être transmises à tous les éléments modulaires voisins (ici aux deux éléments modulaires voisins) ; seul l'élément modulaire destinataire (indiqué comme tel par l'identifiant annexé aux données) tient compte des données transmises pour son fonctionnement. Selon cette variante, dans l'exemple décrit ci-dessus où des données sont transmises de la passerelle de communication 200 au troisième variateur modulaire 102, ces données sont également transmises au premier variateur 100, sans conséquence sur son fonctionnement.

La figure 7 représente schématiquement un exemple d'installation électrique comprenant une pluralité d'appareils électriques conformes à l'invention (ici quatre variateurs modulaires 105, 106, 107, 108) et une passerelle de communication 201.

La passerelle de communication 201 est réalisée sous forme d'un élément modulaire, ici avec un boîtier identique au boîtier de l'élément modulaire de la figure 1, avec une largeur standard de 18 mm.

Ce boîtier renferme toutefois un circuit électrique du type de celui représenté en figure 4, sans l'écran 232 et le clavier 234. La passerelle de communication 201 peut ainsi être connectée à un réseau domotique filaire R au moyen d'un module de communication filaire (référencé 295 en figure 4).

Un dispositif électronique extérieur connecté à la passerelle de communication 201 via le réseau domotique filaire R (ou en variante via une liaison sans fil établie au moyen du module de communication sans fil 290) peut ainsi échanger des données (notamment des informations de commande de charge) avec la passerelle de communication 201. Selon une possibilité de réalisation, une interface homme-machine de ce dispositif extérieur peut être utilisée en tant qu'interface homme-machine de la passerelle de communication 201 (en lieu et place de l'écran 232 et du clavier 234 dans l'exemple des figures 3 et 4).

La passerelle de communication 201 comprend deux antennes 1_{G}, 1_{D} connectées à un module de communication de proximité (référencé 280 en figure 4) et respectivement disposées à proximité d'une paroi latérale du boîtier de la passerelle de communication (et ici essentiellement parallèlement à cette paroi).

La passerelle de communication 201 est branchée d'une part sur un câble de neutre N de l'installation électrique et d'autre part sur un câble de phase P de l'installation électrique pour son alimentation électrique.

Chacun des variateurs modulaires 105, 106, 107, 108 est identique au variateur modulaire décrit ci-dessus en référence aux figures 1 et 2, et comporte ainsi notamment deux antennes (référencées respectivement 5_{G}, 5_{D} pour le variateur modulaire 105 ; 6_{G}, 6_{D} pour le variateur modulaire 106 ; 7_{G}, 7_{D} pour le variateur modulaire 107 ; 8_{G}, 8_{D} pour le variateur modulaire 108) connectées à un module de communication de proximité (référencé 180 en figure 2) et respectivement montées dans la variateur modulaire concerné à proximité d'une paroi latérale du boîtier de ce variateur modulaire (et ici essentiellement parallèlement à cette paroi).

Chaque variateur modulaire 105, 106, 107, 108 comprend ainsi en outre un premier contact d'entrée branché sur le câble de phase P de l'installation électrique, un second contact d'entrée branché sur le câble de neutre N de l'installation électrique et un contact de sortie branché sur une charge (respectivement référencée C₅, C₆, C₇, C₈), avec interposition d'un interrupteur commandé (référencé 170 en figure 2) entre le premier contact d'entrée et le contact de sortie. Chaque charge C₅, C₆, C₇, C₈ est par ailleurs branchée au câble de neutre N de l'installation électrique.

Ces différents éléments modulaires (à savoir la passerelle de communication 201 et les variateurs modulaires 105, 106, 107, 108) sont montés juxtaposés sur un rail de support d'un tableau électrique de l'installation électrique, au moyen notamment d'une encoche formée dans la face arrière du boîtier de chaque élément modulaire, par coopération (par complémentarité de formes) entre l'encoche et le rail, comme expliqué ci-dessus en référence à la figure 1.

Ainsi, comme bien visible en figure 7, chaque élément modulaire 201, 105, 106, 107, 108 est au contact (ou à proximité immédiate) d'au moins un élément modulaire voisin et peut établir une liaison sans fil de proximité (ici une liaison NFC) avec cet élément modulaire voisin au moyen de l'antenne située dans l'élément modulaire concerné à proximité de la paroi (ici latérale) jouxtant l'élément modulaire voisin et de l'antenne située dans l'élément modulaire voisin à proximité de la paroi (ici latérale) jouxtant l'élément modulaire concerné.

La liaison sans fil de proximité ainsi établie permet un échange de données entre l'élément modulaire concerné (en pratique son processeur) et l'élément modulaire voisin (en pratique son processeur) et ainsi, de proche en proche, un échange de données entre deux éléments modulaires quelconques parmi les différents éléments modulaires 201, 105, 106, 107, 108.

Par ailleurs, comme déjà indiqué en référence à la figure 6, un identifiant de l'élément modulaire destinataire des données peut être annexé aux données afin que celles-ci soit prises en compte par l'élément modulaire destinataire seulement.

On décrit à présent un exemple de processus mis en oeuvre dans l'installation de la figure 7 lorsqu'un dispositif électronique extérieur en communication avec la passerelle de communication 201 (ici via le réseau domotique filaire R) émet une commande (par exemple de mise en fonctionnement ou commande ON d'une charge, ici la charge C₈) à destination du variateur modulaire 108 :
- des données représentatives de la commande sont émises sur le réseau R avec un identifiant de l'élément modulaire destinataire de la commande (ici le variateur modulaire 108) ;
- ces données sont reçues par la passerelle de communication 201 au moyen du module de communication filaire 295 ;
- la passerelle de communication 201 (en pratique par exemple son processeur 260) transmet ces données au variateur modulaire 105 (juxtaposé à la passerelle de communication 201 comme visible en figure 7) via la liaison sans fil de proximité établie entre ces deux éléments modulaires au moyen de l'antenne 1_{D} de la passerelle de communication 201 (disposée à proximité de la paroi latérale de la passerelle de communication 201 jouxtant le variateur modulaire 105) et de l'antenne 5_{G} du variateur modulaire 105 (disposée à proximité de la paroi latérale du variateur modulaire 105 jouxtant la passerelle de communication 201);
- les données sont reçues par le processeur du variateur modulaire 105 qui détermine, par consultation de l'identifiant, que ces données ne lui sont pas destinées et transmet par conséquent les données au variateur modulaire 106 (juxtaposé au variateur modulaire 105 comme visible en figure 7) via la liaison sans fil de proximité établie entre ces deux éléments modulaires au moyen de l'antenne 5_{D} du variateur modulaire 105 (disposée à proximité de la paroi latérale du variateur modulaire 105 jouxtant le variateur modulaire 106) et de l'antenne 6_{G} du variateur modulaire 106 (disposée à proximité de la paroi latérale du variateur modulaire 106 jouxtant le variateur modulaire 105) ;
- de même, les données sont reçues par le processeur du variateur modulaire 106 qui détermine, par consultation de l'identifiant, que ces données ne lui sont pas destinées et transmet par conséquent les données au variateur modulaire 107 via la liaison sans fil de proximité établie entre ces deux éléments modulaires au moyen de l'antenne 6_{D} du variateur modulaire 106 et de l'antenne 7_{G} du variateur modulaire 107 ;
- les données sont ainsi reçues par le processeur du variateur modulaire 107 qui détermine, par consultation de l'identifiant, que ces données ne lui sont pas destinées et transmet par conséquent les données au variateur modulaire 108 via la liaison sans fil de proximité établie entre ces deux éléments modulaires au moyen de l'antenne 7_{D} du variateur modulaire 107 et de l'antenne 8_{G} du variateur modulaire 108 ;
- les données sont ainsi reçues par le processeur du variateur modulaire 108 qui détermine, par consultation de l'identifiant, que ces données lui sont destinées et le variateur modulaire 108 utilise par conséquent ces données, ici en effectuant la commande désignée par ces données, à savoir la mise en fonctionnement de la charge C₈ par commande adaptée de l'interrupteur commandé (référencé 170 en figure 1) du variateur modulaire 108.

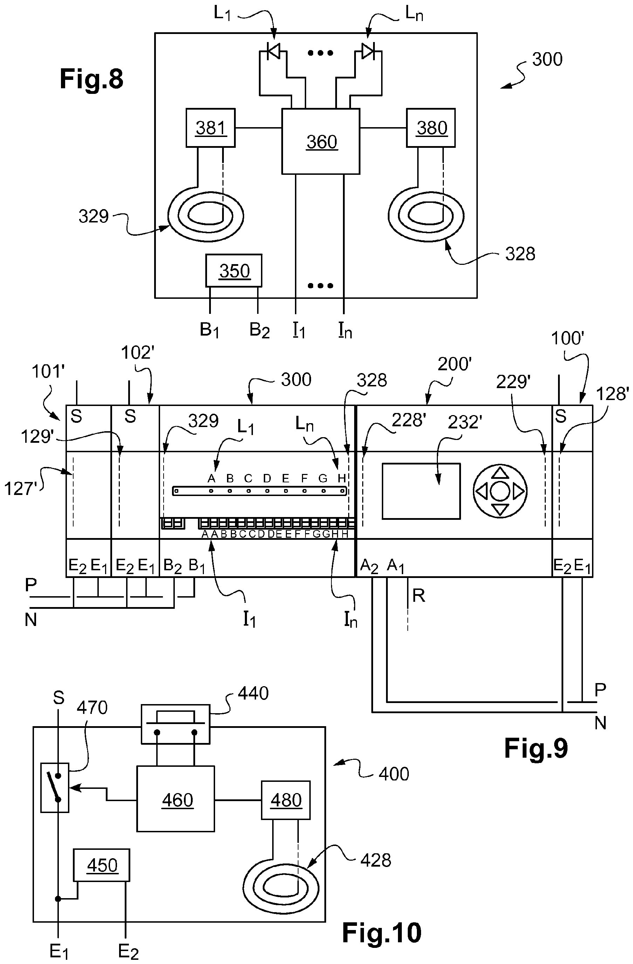

La figure 8 représente les principaux composants d'un élément de commande modulaire 300, réalisé sous forme d'un boîtier de forme globalement parallélépipédique et destiné à être monté dans un tableau électrique, comme l'élément modulaire 100 de la figure 1 et la passerelle de communication 200.

Comme bien visible sur la figure 9 décrite plus bas, l'élément de commande modulaire 300 présente notamment pour ce faire un encombrement latéral standardisé, par exemple multiple de 18 mm.

L'élément de commande modulaire 300 comprend un circuit d'alimentation 350 connecté à deux bornes de connexion B₁, B₂ destinées à recevoir deux câbles d'alimentation de l'installation électrique entre lesquels est présente la tension secteur. Le circuit d'alimentation 350 est conçu pour transformer la tension secteur en tension continue destinée à alimenter les autres composants du circuit électrique de l'élément de commande modulaire 300.

L'élément de commande modulaire 300 comprend un processeur 360 (par exemple un microcontrôleur) relié notamment à un premier module NFC 380 et à un second module NFC 381.

Le premier module NFC 380 est connecté à une première antenne 328 montée dans (ou à proximité d') une paroi latérale du boîtier de l'élément de commande modulaire 300. Le module NFC 380 permet ainsi à l'élément de commande modulaire 300 (c'est-à-dire en pratique à son processeur 360) d'entrer en communication, via une communication sans fil de proximité, avec un autre appareil équipé d'un module NFC et d'échanger des données avec cet autre appareil. Le module NFC 380 forme ainsi un module (ou interface) de communication (sans fil) de proximité.

De même, le second module NFC 381 est connecté à une seconde antenne 329 montée dans (ou à proximité d') une paroi latérale du boîtier (ici opposée à la paroi latérale précité). Le module NFC 381 permet lui aussi à l'élément de commande modulaire 300 (précisément à son processeur 360) d'entrer en communication via une communication sans fil de proximité, avec un autre appareil équipé d'un module NFC et d'échanger des données avec cet autre appareil. Le second module NFC 381 forme ainsi un autre module de communication (sans fil) de proximité.

Le processeur 360 est également relié à une pluralité d'entrées I₁, ..., Iₙ destinées chacune à recevoir un signal électrique provenant d'un élément électrique extérieur à l'élément de commande modulaire 300, par exemple un capteur (tel qu'un capteur de température ou un capteur de présence). Chaque entrée I₁, ..., Iₙ est réalisée physiquement au moyen d'un ou deux contacts accessibles en face avant de l'élément de commande modulaire 300.

Le processeur 360 détecte et/ou mesure les signaux électriques présents sur chacune des entrées I₁, ..., Iₙ, et détermine au moins une information de commande d'une charge (par exemple une commande de mise sous tension d'une charge ou de mise hors tension d'une charge) en fonction d'au moins un desdits signaux détectés et/ou mesurés.

Par ailleurs, selon le signal électrique détecté sur une entrée donnée Iᵢ, le processeur 360 commande l'allumage d'une diode électroluminescente Lᵢ associée à l'entrée concernée, parmi un ensemble de diodes électroluminescentes L₁, ..., Lₙ disposées en façade avant de l'élément de commande modulaire 300.

Le processeur 360 peut également commander l'émission des signaux mesurés ou détectés, ainsi que l'émission de l'information de commande déterminée, au moyen du premier module NFC 380 ou du second module NFC 381, comme dans l'exemple décrit à présent.

La figure 9 représente un exemple d'installation électrique comprenant notamment un tel élément de commande modulaire 300.

L'élément de commande modulaire 300 est monté sur un rail de support d'un tableau électrique au moyen notamment d'une encoche formée dans la face arrière de l'élément de commande modulaire 300, comme cela a été expliqué plus haut pour l'élément modulaire 100 et la passerelle de communication 200.

Dans l'exemple de la figure 9 sont successivement montés sur le rail de support (de droite à gauche) :
- un premier variateur modulaire 100' ;
- une passerelle de communication 200' ;
- l'élément de commande modulaire 300 ;
- un troisième variateur modulaire 102' ;
- un second variateur modulaire 101',
chaque élément étant juxtaposé avec le (ou les) élément(s) voisin(s).

Les variateurs modulaires 100', 101', 102' sont du même type que le variateur modulaire décrit ci-dessus en référence aux figures 1 et 2. On remarque toutefois que chacun de ces variateurs modulaires 100', 101', 102' ne possède qu'une seule antenne 128', 127', 129'. La faible largeur (ici 18 mm) de chaque variateur modulaire 100', 101', 102' permet toutefois à la liaison sans fil de proximité (ici la liaison NFC) de s'établir avec le module de communication sans fil de proximité présent dans l'élément voisin, même lorsque l'élément voisin ne jouxte pas la paroi latérale du variateur modulaire 101', 102' associée à l'antenne 127', 129', mais la paroi latérale opposée. La passerelle de communication 200' est du même type que la passerelle de communication 200 décrite ci-dessus notamment en référence aux figures 3 et 4.

La passerelle de communication 200' comprend une première antenne 228' et une seconde antenne 229' (chaque antenne 228', 229' étant reliée à un module NFC propre).

Du fait de la juxtaposition sur le rail de support de la passerelle de communication 200' et du premier variateur modulaire 100', l'antenne 128' du premier variateur modulaire 100' est située à proximité de la seconde antenne 229' de la passerelle de communication 200' de sorte que des données (notamment des informations de commande de charge) peuvent être échangées entre le premier variateur modulaire 100' et la passerelle de communication 200 via la liaison sans fil de proximité établie entre ces antennes.

Ces échanges de données peuvent permettre notamment des fonctionnalités telles que celles décrites ci-dessus dans le cadre des figures 5 et 6, qui ne seront pas décrites à nouveau ici.

De même, du fait de la juxtaposition sur le rail de support de l'élément de commande modulaire 300 et de la passerelle de communication 200', l'antenne 328 de l'élément de commande modulaire est située à proximité de la première antenne 228' de la passerelle de communication 200' de sorte que des données peuvent être échangées entre l'élément de commande modulaire 300 (précisément son processeur 360) et la passerelle de communication 200' via la liaison sans fil de proximité établie entre ces antennes.

Le processeur 360 de l'élément de commande modulaire 300 peut ainsi transmettre à la passerelle de communication 200' les signaux mesurés ou détectés comme indiqué ci-dessus en référence à la figure 8 et/ou la ou les information(s) de commande déterminée(s) par le processeur 360 en fonction de ces signaux.

La passerelle de communication peut alors par exemple afficher, sur l'écran 232' de la passerelle de communication 200', une valeur représentative d'un signal mesuré reçu et/ou commander le premier variateur 100' en fonction d'une information de commande reçue via la liaison sans fil de proximité susmentionnée et/ou commander un autre appareil électrique en fonction d'une information de commande reçue par émission d'une commande adéquate sur le réseau domotique filaire R.

Comme indiqué ci-dessus, bien que l'antenne 129' du troisième variateur 102' soit placée du côté de la face latérale du troisième variateur 102' opposée à celle située au contact de l'élément modulaire de commande 300, cette antenne 129' est suffisamment proche (à une distance d'environ 18 mm, correspondant à la largeur standardisée du variateur modulaire 102') de la seconde antenne 329 de l'élément de commande modulaire pour permettre l'établissement d'une liaison sans fil de proximité entre le troisième variateur modulaire 102' et l'élément de commande modulaire 300.

De même, la largeur standardisée (ici 18 mm) du second variateur modulaire 101' est suffisamment faible pour permettre l'établissement d'une liaison sans fil de proximité entre le second variateur modulaire 101' et le troisième variateur modulaire 102' au moyen de leurs antennes respectives 127', 129'.

Ainsi, l'élément de commande modulaire 300 peut échanger des données avec le troisième variateur modulaire 102' et, via ce dernier, avec le second variateur modulaire 101'. L'élément de commande modulaire 300 peut alors commander l'un ou l'autre de ces variateurs modulaires 101', 102' en lui transmettant une information de commande déterminée comme indiqué ci-dessus en référence à la figure 8.

La figure 10 représente les éléments principaux d'un autre appareil électrique 400 conforme à l'invention.

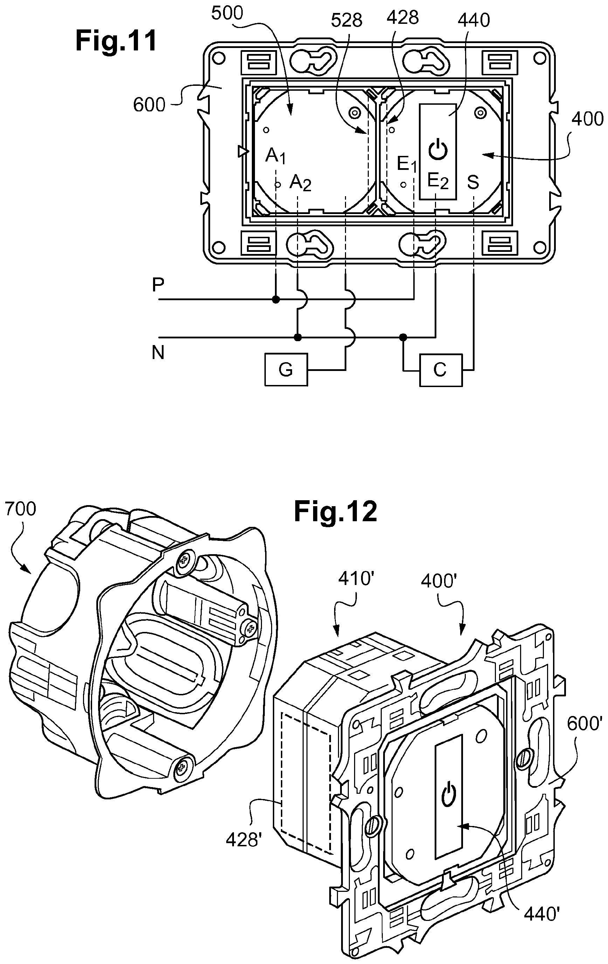

Comme visible sur les figures 11 et 12 décrites plus bas, il s'agit ici d'un appareillage électrique comprenant un mécanisme d'appareillage destiné à être reçu dans une boîte d'encastrement, tel qu'un variateur encastré.

Le variateur encastré 400 présente un premier contact d'entrée E₁, un second contact d'entrée E₂ et un contact de sortie S. Chacun de ces contacts E₁, E₂, S est destiné à être connecté à un câble de l'installation électrique amené dans la boîte d'encastrement.

Ainsi, le premier contact d'entrée E₁ est destiné à être connecté à un câble de phase P de l'installation électrique, le second contact d'entrée E₂ est destiné à être connecté à un câble de neutre N de l'installation électrique et le contact de sortie S est destiné à être connecté à une charge à alimenter par l'intermédiaire du variateur encastré 400.

Le variateur encastré 400 comprend un circuit d'alimentation 450 connecté au premier contact d'entrée E₁ et au second contact d'entrée E₂ et conçu pour transformer la tension secteur en tension continue destinée à alimenter les autres composants du circuit électrique du variateur encastré 400.

Le variateur encastré 400 comprend par ailleurs un processeur 460 (par exemple un microcontrôleur) conçu pour gérer le fonctionnement du variateur encastré 400 et pour commander un interrupteur commandé 470 connecté entre le premier contact d'entrée E₁ et le contact de sortie S, en fonction notamment d'une commande de l'utilisateur reçue au moyen d'un bouton poussoir 440 relié au processeur 460.

Comme déjà indiqué ci-dessus dans le cadre de la figure 1, le processeur 460 est conçu pour commander l'interrupteur commandé 470 de manière à ce que ce dernier ne soit conducteur que pour une partie déterminée de chaque période de la tension secteur et bloqué le reste du temps, ce qui permet de transmettre à la charge une puissance réglable en fonction du rapport cyclique appliqué. Ce rapport cyclique est lui-même déterminé par le processeur 460 en fonction notamment de la commande du bouton poussoir 440 (chaque appui long sur le bouton poussoir entraînant par exemple une variation du rapport cyclique).

Le variateur encastré 400 comprend un module NFC 480 relié au processeur 460, par exemple au moyen d'un bus de données, et connecté à une antenne 428. Le module NFC 480 forme un module (ou interface) de communication (sans fil) de proximité.

Comme visible par exemple sur la figure 12, qui décrit une variante de réalisation du variateur encastré 400, l'antenne 428' est montée à proximité immédiate d'une paroi latérale du mécanisme d'appareillage (ou dans une telle paroi latérale).

La figure 11 représente schématiquement le variateur encastré 400 logé dans une boîte d'encastrement et monté, avec une passerelle de communication 500 réalisée sous forme de mécanisme d'appareillage 500, sur un support d'appareillage commun 600.

La passerelle de communication 500 est réalisée sous forme d'un boîtier généralement parallélépipédique destiné à être placé dans une boîte d'encastrement (telle que la boîte d'encastrement 700 montrée en figure 12). Le circuit électrique de la passerelle de communication 500 est toutefois identique à celui de la figure 4, décrit plus haut. La passerelle de communication 500 comporte ainsi notamment une antenne 528 montée à proximité d'une paroi latérale du boîtier parallélépipédique et reliée à un module NFC (non représenté), équivalent du module NFC 280 en figure 4.

Le variateur encastré 400 et la passerelle de communication 500 sont montés sur un support d'appareillage commun 600 (ici un support d'appareillage à deux postes). Le support d'appareillage commun 600 est lui-même monté (typiquement au moyen de vis auto-taraudeuses) à l'avant d'une boîte d'encastrement à deux postes qui reçoit ainsi le variateur encastré 400 à l'intérieur d'une première cavité de la boîte d'encastrement et la passerelle de communication 500 à l'intérieur d'une seconde cavité de la boîte d'encastrement.

Une telle boîte d'encastrement est montée dans un évidement formé dans une paroi (par exemple une cloison ou un mur) que l'on souhaite équiper des appareils électriques précités.

Le premier contact d'entrée E₁ du variateur encastré 400 et une borne de connexion A₁ de la passerelle de communication 500 sont branchés sur la phase P de l'installation électrique. Le second contact d'entrée E₂ du variateur encastré 400 et l'autre borne de connexion A₂ de la passerelle de communication 500 sont branchés sur le neutre N de l'installation électrique. Une charge C est branchée entre le contact de sortie S du variateur encastré 400 et le neutre N.

Par ailleurs, un câble d'un réseau domotique filaire R est branché sur une prise media (non représentée) de la passerelle de communication 500, ce qui permet notamment de relier un gestionnaire G de l'installation électrique à la passerelle de communication 500 via le réseau domotique R.

Du fait que le variateur encastré 400 et la passerelle de communication 500 sont montés côte à côte dans une boîte d'encastrement, l'antenne 428 du variateur encastré 400 et l'antenne 528 de la passerelle de communication 500 sont suffisamment proches pour permettre l'établissement d'une liaison sans fil de proximité (ici une liaison NFC) entre le variateur encastré 400 et la passerelle de communication 500.

Le variateur encastré 400 et la passerelle de communication 500 peuvent ainsi échanger des données, en particulier des informations de commande d'une charge, via la liaison sans fil de proximité établie, notamment :
- la passerelle de communication 500 peut recevoir du gestionnaire G une information de commande de la charge C (par exemple une information de mise sous tension de la charge C ou une information de mise hors tension de la charge C) et transmettre cette information au variateur encastré 400 (précisément au processeur 460) via la liaison sans fil de proximité de sorte que le processeur 460 commande l'interrupteur commandé 470 conformément à cette information ;
- la passerelle de communication 500 peut recevoir via la liaison sans fil de proximité une information de commande d'une autre charge en provenance du processeur 460 (information déterminée par exemple selon une durée et/ou une séquence d'appui sur le bouton poussoir 440) et transmettre cette information à l'autre charge via le réseau domotique filaire R (soit directement, soit par l'intermédiaire du gestionnaire G).

La figure 12 représente une variante de réalisation du variateur encastré de la figure 10.

Le variateur encastré 400' de la figure 12 est également réalisé sous forme d'un appareillage électrique comprenant un mécanisme d'appareillage reçu dans un boîtier 410' (de forme généralement parallélépipédique) et un support d'appareillage 600'.

Le mécanisme d'appareillage 400' présente en façade avant un bouton poussoir 440' (qui correspond au bouton-poussoir 440 de la figure 10) et comporte, à proximité d'une face latérale du boîtier 410' (ou dans cette face latérale), une antenne 428' (qui correspond à l'antenne 428 de la figure 10).

Le support 600' est conçu pour être fixé à l'avant d'une boîte d'encastrement 700 de sorte que le mécanisme d'appareillage 400' soit reçu à l'intérieur de la boîte d'encastrement 700. L'antenne 428' a alors un positionnement bien déterminé et peut participer à l'établissement d'une liaison sans fil de proximité avec une autre antenne située dans un autre appareil électrique monté à proximité (par exemple dans une autre boîte d'encastrement fixée dans une paroi à proximité de la boîte d'encastrement 700).

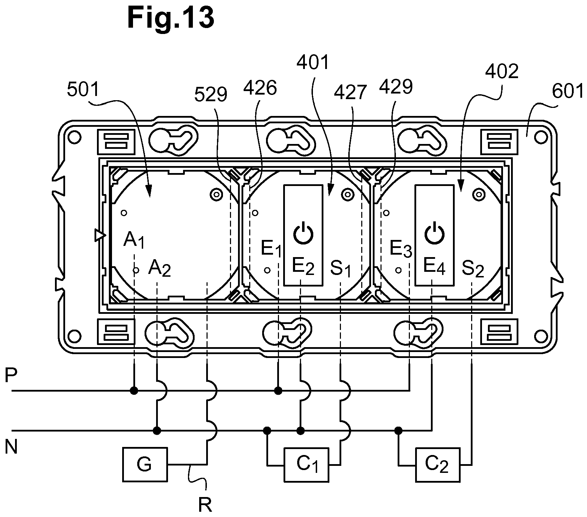

La figure 13 représente schématiquement un support d'appareillage 601 pourvu de trois appareils électriques comprenant chacun au moins une antenne et un module de communication en champ proche associé.

Ces trois appareils électriques sont ici une passerelle de communication 501, un premier variateur encastré 401 et un second variateur encastré 402, montés juxtaposés (et alignés) dans cet ordre sur le support d'appareillage (commun) 601.

Le support d'appareillage commun 601 peut être monté (typiquement au moyen de vis auto-taraudeuses) à l'avant d'une boîte d'encastrement à trois postes (non représentée) qui reçoit ainsi la passerelle de communication 501 à l'intérieur d'une première cavité de la boîte d'encastrement, le premier variateur encastré 401 à l'intérieur d'une seconde cavité de la boîte d'encastrement et le second variateur encastré 402 à l'intérieur d'une troisième cavité de la boîte d'encastrement.

Une telle boîte d'encastrement est montée dans un évidement formé dans une paroi (par exemple une cloison ou un mur) que l'on souhaite équiper des appareils électriques précités.

Chacun des premier et second variateurs encastrés 401, 402 est du type du variateur encastré 400 décrit ci-dessus en référence à la figure 10. La passerelle de communication 501 est du type de la passerelle de communication 500 mentionnée ci-dessus. On pourra ainsi se référer à la description donnée plus haut pour plus de détail sur ces appareils électriques 401, 402, 501.

Ainsi, le premier contact d'entrée E₁ du premier variateur encastré 401, le premier contact d'entrée E₃ du second variateur encastré 402 et une borne de connexion A₁ de la passerelle de communication 501 sont branchés sur la phase P de l'installation électrique. Le second contact d'entrée E₂ du premier variateur encastré 401, le second contact d'entrée E₄ du second variateur encastré 402 et l'autre borne de connexion A₂ de la passerelle de communication 501 sont branchés sur le neutre N de l'installation électrique. Une première charge C₁ est branchée entre le contact de sortie S₁ du premier variateur encastré 401 et le neutre N ; une seconde charge C₂ est branchée entre le contact de sortie S₂ du second variateur encastré 402 et le neutre N.

Par ailleurs, un câble d'un réseau domotique filaire R est branché sur une prise media (non représentée) de la passerelle de communication 501, ce qui permet notamment de relier un gestionnaire G de l'installation électrique à la passerelle de communication 501 via le réseau domotique R.

Du fait de la disposition des appareils électriques 401, 402, 501 sur le support d'appareillage 601, chacun de ces appareils électriques (variateur encastré ou passerelle de communication) est au contact, au niveau d'une au moins de ces parois latérales, du ou des appareil(s) électrique(s) voisin(s).

Le premier variateur encastré 401 comprend deux antennes 426, 427 disposées chacune à proximité immédiate d'une paroi latérale du premier variateur encastré 401 (par exemple parallèlement à cette paroi latérale).

Le second variateur encastré 402 comprend au moins une antenne 429, située ici à proximité immédiate d'une paroi latérale du second variateur encastré 402 (laquelle paroi latérale jouxte le premier variateur encastré 401).

La passerelle de communication 501 comprend quant à elle au moins une antenne 529, située ici à proximité immédiate d'une paroi latérale de la passerelle de communication 501 (laquelle paroi latérale jouxte le premier variateur encastré 401).

Du fait que le premier variateur encastré 401 et la passerelle de communication 501 sont juxtaposés sur le support d'appareillage 601, l'antenne 426 du premier variateur encastré 401 et l'antenne 529 de la passerelle de communication 501 sont suffisamment proches pour permettre l'établissement d'une liaison sans fil de proximité (ici une liaison NFC) entre le premier variateur encastré 401 et la passerelle de communication 501 (chaque appareil électrique 401, 501 étant équipé comme déjà indiqué d'un module de communication en champ proche associé à l'antenne 426, 529 de cet appareil).

De même, du fait que le premier variateur encastré 401 et le second variateur encastré 402 sont juxtaposés sur le support d'appareillage 601, l'antenne 427 du premier variateur encastré 401 et l'antenne 429 du second variateur encastré 402 sont suffisamment proches pour permettre l'établissement d'une liaison sans fil de proximité (ici une liaison NFC) entre le premier variateur encastré 401 et le second variateur encastré 402 (chaque appareil électrique 401, 402 étant équipé comme déjà indiqué d'un module de communication en champ proche associé à l'antenne 427, 429 de cet appareil).

Les trois appareils électriques montés sur le support d'appareillage 601 (ici le premier variateur encastré 401, le second variateur encastré 402 et la passerelle de communication 501) peuvent ainsi échanger des données, en particulier des informations de commande d'une charge, via les liaisons sans fil de proximité établies entre les appareils deux à deux. En particulier :
- la passerelle de communication 501 peut recevoir du gestionnaire G une information de commande de la première charge C₁ ou de la seconde charge C₂ (par exemple une information de mise sous tension de la charge concernée C₁, C₂ ou une information de mise hors tension de la charge concernée C₁, C₂) et transmettre cette information au variateur encastré concerné 401, 402 via la liaison sans fil de proximité (ou les liaisons sans fil de proximité) de sorte que le processeur du variateur encastré concerné 401, 402 commande l'interrupteur commandé du variateur encastré concerné 401, 402 conformément à cette information ;
- la passerelle de communication 501 peut recevoir via la liaison sans fil de proximité (ou les liaisons sans fil de proximité) une information de commande d'une autre charge en provenance du processeur du premier variateur encastré 401 ou du second variateur encastré 402 (information déterminée par exemple selon une durée et/ou une séquence d'appui sur le bouton poussoir du variateur encastré concerné 401, 402) et transmettre cette information à l'autre charge via le réseau domotique filaire R (soit directement, soit par l'intermédiaire du gestionnaire G).

En effet, comme déjà indiqué, chaque appareil électrique 401, 402, 501 est au contact (ou à proximité immédiate) d'au moins un appareil électrique voisin et peut établir une liaison sans fil de proximité (ici une liaison NFC) avec cet appareil électrique voisin au moyen de l'antenne située dans l'appareil électrique concerné à proximité de la paroi (ici latérale) jouxtant l'appareil électrique voisin et de l'antenne située dans l'appareil électrique voisin à proximité de la paroi (ici latérale) jouxtant l'appareil électrique concerné.

La liaison sans fil de proximité ainsi établie permet un échange de données entre l'appareil électrique concerné (en pratique son processeur) et l'appareil électrique voisin (en pratique son processeur) et ainsi, de proche en proche, un échange de données entre deux appareils électriques quelconques parmi les différents appareils électriques 401, 402, 501.

Par ailleurs, comme déjà indiqué dans les cas des éléments modulaires, un identifiant de l'appareil électrique destinataire des données peut être annexé aux données afin que celles-ci soit prises en compte par l'appareil électrique destinataire seulement.

On décrit à présent un exemple de processus mis en oeuvre dans l'ensemble de la figure 13 lorsqu'un dispositif électronique extérieur en communication avec la passerelle de communication 501 (ici via le réseau domotique filaire R) émet une commande (par exemple de mise en fonctionnement ou commande ON d'une charge, ici la charge C₂) à destination du second variateur encastré 402 :
- des données représentatives de la commande sont émises sur le réseau R avec un identifiant de l'élément modulaire destinataire de la commande (ici le second variateur encastré 402) ;
- ces données sont reçues par la passerelle de communication 501 au moyen de son module de communication filaire ;
- la passerelle de communication 501 (en pratique par exemple son processeur) transmet ces données au premier variateur encastré 401 (juxtaposé à la passerelle de communication 501 comme visible en figure 13) via la liaison sans fil de proximité établie entre ces deux appareils électriques au moyen de l'antenne 529 de la passerelle de communication 501 (disposée à proximité de la paroi latérale de la passerelle de communication 501 jouxtant le premier variateur encastré 401) et de l'antenne 426 du premier variateur encastré 401 (disposée à proximité de la paroi latérale du premier variateur encastré 401 jouxtant la passerelle de communication 501) ;

- les données sont reçues par le processeur du premier variateur encastré 401 qui détermine, par consultation de l'identifiant, que ces données ne lui sont pas destinées et transmet par conséquent les données au second variateur encastré 402 (juxtaposé au premier variateur encastré 401 comme visible en figure 13) via la liaison sans fil de proximité établie entre ces deux appareils électriques au moyen de l'antenne 427 du premier variateur encastré 401 (disposée à proximité de la paroi latérale du premier variateur encastré 401 jouxtant le second variateur encastré 402) et de l'antenne 429 du second variateur encastré 402 (disposée à proximité de la paroi latérale du second variateur encastré 402 jouxtant le premier variateur encastré 401) ;
- les données sont ainsi reçues par le processeur du second variateur encastré 402 qui détermine, par consultation de l'identifiant, que ces données lui sont destinées et le second variateur encastré 402 utilise par conséquent ces données, ici en effectuant la commande désignée par ces données, à savoir la mise en fonctionnement de la charge C₂ par commande adaptée de l'interrupteur commandé du second variateur encastré 402.

## Revendications

1. Appareil électrique comprenant :
- un boîtier (110 ; 210 ; 410') comportant des moyens de positionnement (122, 123 ; 222 ; 600 ; 600' ; 601) dans un réceptacle d'appareillage électrique (700) ;
- un circuit électronique (160 ; 260 ; 360 ; 460) conçu pour manipuler une information de commande d'une charge ;
- au moins une antenne (128 ; 228 ; 127 ; 129 ; 328, 329 ; 428 ; 428' ; 426, 427 ; 429 ; 529) ; et
- un module de communication de proximité (180 ; 280 ; 380, 381 ; 480) connecté à l'antenne (128 ; 228 ; 127 ; 129 ; 328, 329 ; 428 ; 428' ; 426, 427 ; 429 ; 529) et relié au circuit électronique (160 ; 260 ; 360 ; 460), le circuit électronique (160 ; 260 ; 360 ; 460) étant conçu pour recevoir des données via une liaison sans fil de proximité établie entre l'appareil électrique (105 ; 200 ; 300 ; 401) et un premier appareil électrique voisin (201 ; 100 ; 102' ; 501) **caractérisé en ce que** le circuit électronique est en plus conçu pour transmettre lesdites données via une liaison sans fil de proximité établie entre l'appareil électrique (105 ; 200 ; 300 ; 401) et un second appareil électrique voisin (106 ; 101 ; 200' ; 402).

2. Appareil électrique selon la revendication 1, comprenant au moins un contact d'entrée (E₁), un contact de sortie (S) et un interrupteur commandé (170 ; 470) conçu pour commander l'ouverture ou la fermeture d'un chemin électrique entre le contact d'entrée (E₁) et le contact de sortie (S), dans lequel le circuit électronique (160 ; 460) est conçu pour commander l'interrupteur commandé (170 ; 470) en fonction de ladite information de commande.

3. Appareil électrique selon la revendication 1 ou 2, dans lequel l'antenne (128 ; 228 ; 428') est montée à proximité d'une paroi (116 ; 216) du boîtier (110 ; 210 ; 410').

4. Appareil électrique selon la revendication 1 ou 2, dans lequel l'antenne (128 ; 228 ; 428') est une antenne plane intégrée dans une paroi (116 ; 216) du boîtier (110 ; 210 ; 410').

5. Appareil électrique selon la revendication 3 ou 4, dans lequel la paroi est une paroi latérale (116 ; 216) du boîtier (110 ; 210).

6. Appareil électrique selon l'une des revendications 1 à 5, dans lequel le boîtier (110 ; 210 ; 410') comporte deux antennes (128 ; 5_{D}, 5_{G} ; 6_{D}, 6_{G} ; 7_{D}, 7_{G} ; 8_{D}, 8_{G} ; 328 ; 329 ; 426, 427) situées respectivement à proximité de deux parois (116) du boîtier (110).

7. Appareil électrique selon l'une des revendications 1 à 6, dans lequel les moyens de positionnement comprennent une encoche (122 ; 222) de montage sur un rail de support.

8. Appareil électrique selon l'une des revendications 1 à 6, dans lequel les moyens de positionnement comprennent un support d'appareillage (600 ; 600' ; 601).

9. Appareil électrique selon l'une des revendications 1 à 8, dans lequel le circuit électronique (160 ; 260 ; 360 ; 460) est conçu pour transmettre lesdites données via la liaison sans fil de proximité établie entre l'appareil électrique (105 ; 200 ; 300 ; 401) et le second appareil électrique voisin (106 ; 101 ; 200' ; 402) suite à une consultation d'un identifiant du second appareil électrique voisin (106 ; 101 ; 200' ; 402) annexé auxdites données.

10. Système comprenant un premier appareil électrique (100 ; 101 ; 105 ; 106 ; 107 ; 101' ; 102' ; 300 ; 200' ; 400 ; 401 ; 501) selon l'une des revendications 1 à 9 et un second appareil électrique (200 ; 102 ; 106 ; 107 ; 108 ; 102' ; 300 ; 200' ; 100' ; 500 ; 402 ; 401) selon l'une des revendications 1 à 9, dans lequel le premier appareil électrique (100 ; 101 ; 105 ; 106 ; 107 ; 101' ; 102' ; 300 ; 200' ; 400 ; 401 ; 501) et le second appareil électrique (200 ; 102 ; 106 ; 107 ; 108 ; 102' ; 300 ; 200' ; 100' ; 500 ; 402 ; 401) sont juxtaposés de manière à établir une communication sans fil de proximité entre le module de communication de proximité du premier appareil électrique (100 ; 101 ; 105 ; 106 ; 107 ; 101' ; 102' ; 300 ; 200' ; 400 ; 401 ; 501) et le module de communication de proximité du second appareil électrique (200 ; 102 ; 106 ; 107 ; 108 ; 102' ; 300 ; 200' ; 100' ; 500 ; 402 ; 401).

11. Système selon la revendication 10, dans lequel le premier appareil électrique (100 ; 101 ; 105 ; 106 ; 107 ; 101' ; 102' ; 300 ; 200') et le second appareil électrique (200 ; 102 ; 106 ; 107 ; 108 ; 102' ; 300 ; 200' ; 100') sont montés juxtaposés sur un rail de support d'un tableau électrique.

12. Système selon la revendication 10, dans lequel le premier appareil électrique (400 ; 401 ; 501) et le second appareil électrique (500 ; 402 ; 401) sont montés juxtaposés dans une boîte d'encastrement (700).

13. Système selon l'une des revendications 10 à 12, comprenant en outre un troisième appareil électrique (101 ; 107 ; 108 ; 300 ; 200' ; 100' ; 402) selon l'une des revendication 1 à 9, dans lequel le second appareil électrique (200 ; 106 ; 107 ; 102' ; 300 ; 200' ; 401) et le troisième appareil électrique (101 ; 107 ; 108 ; 300 ; 200' ; 100' ; 402) sont juxtaposés de manière à établir une communication sans fil de proximité entre le module de communication de proximité du second appareil électrique (200 ; 106 ; 107 ; 102' ; 300 ; 200' ; 401) et le module de communication de proximité du troisième appareil électrique (101 ; 107 ; 108 ; 300 ; 200' ; 100' ; 402).

14. Procédé mis en oeuvre dans un système selon la revendication 13, comprenant les étapes suivantes :
- transmission de données du premier appareil électrique (100 ; 105 ; 106 ; 101' ; 102' ; 300 ; 501) au second appareil électrique (200 ; 106 ; 107 ; 102' ; 300 ; 200' ; 401) via la communication sans fil de proximité établie entre le module de communication de proximité du premier appareil électrique (100 ; 105 ; 106 ; 101' ; 102' ; 300 ; 501) et le module de communication de proximité du second appareil électrique (200 ; 106 ; 107 ; 102' ; 300 ; 200' ; 401) ;
- transmission desdites données du second appareil électrique (200 ; 106 ; 107 ; 102' ; 300 ; 200' ; 401) au troisième appareil électrique (101 ; 107 ; 108 ; 300 ; 200' ; 100' ; 402) via la communication sans fil de proximité établie entre le module de communication de proximité du second appareil électrique (200 ; 106 ; 107 ; 102' ; 300 ; 200' ; 401) et le module de communication de proximité du troisième appareil électrique (101 ; 107 ; 108 ; 300 ; 200' ; 100' ; 402).

## Patentansprüche

1. Elektrisches Gerät mit
- einem Gehäuse (110; 210; 410), das Mittel (122, 123; 222; 600, 600'; 601) zum Positionieren in einer Aufnahme (700) für elektrisches Gerät aufweist,
- einer elektronischen Schaltung (160; 260; 360; 460) die dazu ausgelegt ist, eine Steuerungsinformation einer Last zu verarbeiten,
- wenigstens einer Antenne (128; 228; 127; 129; 328, 329; 428; 428'; 426, 427; 429; 529) und
- einem an die Antenne (128; 228; 127; 129; 328, 329; 428; 428'; 426, 427; 429; 529) angeschlossenen und mit der elektronischen Schaltung (160; 260; 360; 460) verbundenen Nahkommunikationsmodul (180; 280; 380, 381; 480),
wobei die elektronische Schaltung (160; 260; 360; 460) dazu ausgelegt ist, Daten über eine zwischen dem elektrischen Gerät (105; 200; 300; 401) und einem ersten elektrischen Nachbargerät (201; 100; 102'; 501) eingerichtete drahtlose Nahverbindung zu erhalten, **dadurch gekennzeichnet, daß** die elektronische Schaltung außerdem dazu ausgelegt ist, die besagten Daten über eine zwischen dem elektrischen Gerät (105; 200; 300; 401) und einem zweiten elektrischen Nachbargerät (106; 101; 200'; 402) eingerichtete drahtlose Nahverbindung zu übermitteln.

2. Elektrisches Gerät gemäß Anspruch 1, das wenigstens einen Eingangskontakt (E₁), einen Ausgangskontakt (S) und einen gesteuerten Schalter (170; 470), der dazu ausgelegt ist, das Öffnen oder das Schließen eines elektrischen Pfads zwischen dem Eingangskontakt (E₁) und dem Ausgangskontakt (S) zu steuern, aufweist, bei dem die elektronische Schaltung (160; 460) dazu ausgelegt ist, den gesteuerten Schalter (170; 470) in Abhängigkeit von der Steuerungsinformation zu steuern.

3. Elektrisches Gerät gemäß Anspruch 1 oder 2, bei dem die Antenne (128; 228; 428') in der Nähe einer Wand (116; 216) des Gehäuses (110; 210; 410') angebracht ist.

4. Elektrisches Gerät gemäß Anspruch 1 oder 2, bei dem die Antenne (128; 228; 428') eine ebene, in eine Wand (116; 216) des Gehäuses (110; 210; 410') eingelassene Antenne ist.

5. Elektrisches Gerät gemäß Anspruch 3 oder 4, bei dem die Wand eine Seitenwand (116; 216) des Gehäuses (110; 210) ist.

6. Elektrisches Gerät gemäß einem der Ansprüche 1 bis 5, bei dem das Gehäuse (110; 210; 410') zwei jeweils in der Nähe von zwei Wänden (116) des Gehäuses (110) angeordnete Antennen (128; 5_{D}, 5_{G}; 6_{D}, 6_{G}; 7_{D}, 7_{G}; 8_{D}, 8_{G}; 328; 329; 426, 427) aufweist.

7. Elektrisches Gerät gemäß einem der Ansprüche 1 bis 6, bei dem die Positionierungsmittel eine Montageeinkerbung (122; 222) auf einer Trägerschiene aufweisen.

8. Elektrisches Gerät gemäß einem der Ansprüche 1 bis 6, bei dem die Positionierungsmittel einen Geräteträger (600; 600'; 601) aufweisen.

9. Elektrisches Gerät gemäß einem der Ansprüche 1 bis 8, bei dem die elektronische Schaltung (160; 260; 360; 460) dazu ausgelegt ist, die besagten Daten über die zwischen dem elektrischen Gerät (105; 200; 300; 401) und dem zweiten elektrischen Nachbargerät (106; 101; 200'; 402) eingerichtete drahtlose Nahverbindung nach Abfrage einer an die Daten angehängten Kennung des zweiten elektrischen Nachbargeräts (106; 101; 200'; 402) zu übermitteln.

10. System, das ein erstes elektrisches Gerät (100; 101; 105; 106; 107; 101'; 102'; 300; 200'; 400; 401; 501) gemäß einem der Ansprüche 1 bis 9 und ein zweites elektrisches Gerät (200; 102; 106; 107; 108; 102'; 300; 200'; 100'; 500; 402; 401) gemäß einem der Ansprüche 1 bis 9 aufweist, bei dem das erste elektrische Gerät (100; 101; 105; 106; 107; 101'; 102'; 300; 200'; 400; 401; 501) und das zweite elektrische Gerät (200; 102; 106; 107; 108; 102'; 300; 200'; 100'; 500; 402; 401) nebeneinander angeordnet sind, um eine drahtlose Nahverbindung zwischen dem Nahkommunikationsmodul des ersten elektrischen Geräts (100; 101; 105; 106; 107; 101'; 102'; 300; 200'; 400; 401; 501) und dem Nahkommunikationsmodul des zweiten elektrischen Geräts (200; 102; 106; 107; 108; 102'; 300; 200'; 100'; 500; 402; 401) einzurichten.

11. System gemäß Anspruch 10, bei dem das erste elektrische Gerät (100; 101; 105; 106; 107; 101'; 102'; 300; 200') und das zweite elektrische Gerät (200; 102; 106; 107; 108; 102'; 300; 200'; 100') auf einer Trägerschiene einer elektrischen Tafel nebeneinander angeordnet sind.

12. System gemäß Anspruch 10, bei dem das erste elektrische Gerät (400; 401; 501) und das zweite elektrische Gerät (500; 402; 401) in einer Einbaudose (700) nebeneinander angeordnet sind.

13. System gemäß einem der Ansprüche 10 bis 12, das außerdem ein drittes elektrisches Gerät (101; 107; 108; 300; 200'; 100'; 402) gemäß einem der Ansprüche 1 bis 9 aufweist, bei dem das zweite elektrische Gerät (200; 106; 107; 102'; 300; 200'; 401) und das dritte elektrische Gerät (101; 107; 108; 300; 200'; 100'; 402) nebeneinander angeordnet sind, um eine drahtlose Nahverbindung zwischen dem Nahkommunikationsmodul des zweiten elektrischen Geräts (200; 106; 107; 102'; 300; 200'; 401) und dem Nahkommunikationsmodul des dritten elektrischen Geräts (101; 107; 108; 300; 200'; 100'; 402) einzurichten.

14. Verfahren, das in einem System gemäß Anspruch 13 durchgeführt wird und das die folgenden Schritte aufweist:
- Übertragung von Daten vom ersten elektrischen Gerät (100; 105; 106; 101'; 102'; 300; 501) an das zweite elektrische Gerät (200; 106; 107; 102'; 300; 200'; 401) über die zwischen dem Nahkommunikationsmodul des ersten elektrischen Geräts (100; 105; 106; 101'; 102'; 300; 501) und dem Nahkommunikationsmodul des zweiten elektrischen Geräts (200; 106; 107; 102'; 300; 200'; 401) eingerichtete drahtlose Nahverbindung;
- Übertragung der besagten Daten vom zweiten elektrischen Gerät (200; 106; 107; 102'; 300; 200'; 401) an das dritte elektrische Gerät (101; 107; 108; 300; 200'; 100'; 402) über die zwischen dem Nahkommunikationsmodul des zweiten elektrischen Geräts (200; 106; 107; 102'; 300; 200'; 401) und dem Nahkommunikationsmodul des dritten elektrischen Geräts (101; 107; 108; 300; 200'; 100'; 402) eingerichtete drahtlose Nahverbindung.

## Claims

1. An electrical accessory comprising:
- a casing (110; 210; 410') that includes positioner means (122, 123; 222; 600; 600'; 601) for positioning in an electrical accessory container (700); and
- an electronic circuit (160; 260; 360; 460) that is designed to manipulate control information for controlling a load;
- at least one antenna (128; 228; 127; 129; 328, 329; 428; 428'; 426, 427; 429; 529), and
- a proximity communication module (180; 280; 380, 381; 480) that is connected to the antenna (128; 228; 127; 129; 328, 329; 428; 428'; 426, 427; 429; 529) and linked to the electronic circuit (160; 260; 360; 460), the electronic circuit (160; 260; 360; 460) being designed to receive data via a wireless proximity connection set up between the electrical accessory (105; 200; 300; 401) and a first neighbouring electrical accessory (201; 100; 102'; 501), **characterised in that** the electronic circuit is furthermore designed to transmit said data via a wireless proximity connection set up between the electrical accessory (105; 200; 300; 401) and a second neighbouring electrical accessory (106; 101; 200'; 402).

2. An electrical accessory according to claim 1, including at least one inlet contact (E₁), one outlet contact (S), and one controlled switch (170; 470) that is designed to open and close an electrical path between the inlet contact (E₁) and the outlet contact (S), wherein the electronic circuit (160; 460) is designed to control the controlled switch (170; 470) as a function of said control information.

3. An electrical accessory according to claim 1 or claim 2, wherein the antenna (128; 228; 428') is mounted in the proximity of a wall (116; 216) of the casing (110; 210; 410').

4. An electrical accessory according to claim 1 or claim 2, wherein the antenna (128; 228; 428') is a plane antenna that is incorporated in a wall (116; 216) of the casing (110; 210; 410').

5. An electrical accessory according to claim 3 or claim 4, wherein the wall is a side wall (116; 216) of the casing (110; 210).

6. An electrical accessory according to any one of claims 1 to 5, wherein the casing (110; 210; 410') includes two antennas (128; 5_{D}, 5_{G}; 6_{D}, 6_{G}; 7_{D}, 7_{G}; 8_{D}, 8_{G}; 328; 329; 426, 427) that are situated in the proximity of two respective walls (116) of the casing (110).

7. An electrical accessory according to any one of claims 1 to 6, wherein the positioner means include a mounting notch (122; 222) in a support rail.

8. An electrical accessory according to any one of claims 1 to 6, wherein the positioner means comprise an accessory support (600; 600'; 601).

9. An electrical accessory according to any one of claims 1 to 8, wherein the electronic circuit (160; 260; 360; 460) is designed to transmit said data via the wireless proximity connection set up between the electrical accessory (105; 200; 300; 401) and the second neighbouring electrical accessory (106; 101; 200'; 402) after consulting an identifier of the second neighbouring electrical accessory (106; 101; 200'; 402) appended to said data.

10. A system comprising a first electrical accessory (100; 101; 105; 106; 107; 101'; 102'; 300; 200'; 400; 401; 501) according to any one of claims 1 to 9, and a second electrical accessory (200; 102; 106; 107; 108; 102'; 300; 200'; 100'; 500; 402; 401) according to any one of claims 1 to 9, wherein the first electrical accessory (100; 101; 105; 106; 107; 101'; 102'; 300; 200'; 400; 401; 501) and the second electrical accessory (200; 102; 106; 107; 108; 102'; 300; 200'; 100'; 500; 402; 401) are juxtaposed so as to set up a wireless proximity communication between the proximity communication module of the first electrical accessory (100; 101; 105; 106; 107; 101'; 102'; 300; 200'; 400; 401; 501) and the proximity communication module of the second electrical accessory (200; 102; 106; 107; 108; 102'; 300; 200'; 100'; 500; 402; 401).

11. A system according to claim 10, wherein the first electrical accessory (100; 101; 105; 106; 107; 101'; 102'; 300; 200') and the second electrical accessory (200; 102; 106; 107; 108; 102'; 300; 200'; 100') are mounted juxtaposed on a support rail of an electrical panel.

12. A system according to claim 10, wherein the first electrical accessory (400; 401; 501) and the second electrical accessory (500; 402; 401) are mounted juxtaposed in a flush-mounted box (700).

13. A system according to any one of claims 10 to 12, further including a third electrical accessory (101; 107; 108; 300; 200'; 100'; 402) according to any one of claims 1 to 9, wherein the second electrical accessory (200; 106; 107; 102'; 300; 200'; 401) and the third electrical accessory (101; 107; 108; 300; 200'; 100'; 402) are juxtaposed so as to set up a wireless proximity communication between the proximity communication module of the second electrical accessory (200; 106; 107; 102'; 300; 200'; 401) and the proximity communication module of the third electrical accessory (101; 107; 108; 300; 200'; 100'; 402).

14. A method that is implemented in a system according to claim 13, the method comprising the following steps:
• the first electrical accessory (100; 105; 106; 101'; 102'; 300; 501) transmitting data to the second electrical accessory (200; 106; 107; 102'; 300; 200'; 401) via the wireless proximity communication set up between the proximity communication module of the first electrical accessory (100; 105; 106; 101'; 102'; 300; 501) and the proximity communication module of the second electrical accessory (200; 106; 107; 102'; 300; 200'; 401); and
• the second electrical accessory (200; 106; 107; 102'; 300; 200'; 401) transmitting said data to the third electrical accessory (101; 107; 108; 300; 200'; 100'; 402) via the wireless proximity communication set up between the proximity communication module of the second electrical accessory (200; 106; 107; 102'; 300; 200'; 401) and the proximity communication module of the third electrical accessory (101; 107; 108; 300; 200'; 100'; 402) .
